# FASCICULE DE BREVET EUROPEEN

(11) **EP 2 629 998 B1**
(45) Date de publication et mention de la délivrance du brevet: **20.05.2020**
(21) Numéro de dépôt: 11768054.6
(22) Date de dépôt: 14.10.2011
(51) Int. Cl.: B60L 3/00, G01R 31/00

(54) **DISPOSITIF ET PROCEDE D'ESTIMATION D'UN COURANT DE TOUCHER ET DE PROTECTION D'UN APPAREIL ELECTRIQUE CONTRE DE TELS COURANTS DE TOUCHER**
VORRICHTUNG UND VERFAHREN ZUR KALKULATION EINES BERÜHRUNGSSTROMS UND SCHUTZ EINER ELEKTRISCHEN VORRICHTUNG VOR DERARTIGEN BERÜHRUNGSSTRÖMEN
DEVICE AND METHOD FOR ESTIMATING A TOUCH CURRENT AND PROTECTING AN ELECTRICAL APPARATUS AGAINST SUCH TOUCH CURRENTS

(30) Priorité: 21.10.2010 FR 1058615
(43) Date de publication de la demande: 28.08.2013
(73) Titulaire: Renault S.A.S., 92100 Boulogne-Billancourt (FR)
(72) Inventeur: PLOIX, Olivier, F-78640 Villiers Saint Frédéric (FR); RIPOLL, Christophe, F-78460 Chevreuse (FR)
(86) Numéro de dépôt international: PCT/EP2011/068022
(87) Numéro de publication internationale: WO 2012/052366

(56) Documents cités:
- EP-A1- 2 233 344
- EP-A2- 2 236 344
- WO-A1-2006/035959
- DE-A1-102004 057 694
- FR-A1- 2 701 176
- JP-A- 11 205 909
- US-A- 5 245 495

## Description

L'invention concerne la protection d'appareils électriques contre des courants de fuite et plus particulièrement la protection de chargeurs de batterie de véhicules électriques contre les courants de fuite susceptibles d'apparaître lors du branchement du chargeur sur un réseau de distribution d'énergie électrique.

Les chargeurs utilisés dans certains véhicules automobiles électriques ne sont pas isolés. Chaque élément du chargeur présente une capacité de mode commun par rapport au châssis. Lors du raccordement à un réseau de distribution d'énergie électrique, les tensions appliquées à ces différents éléments vont provoquer, à travers ces capacités, des courants de fuite à la terre.

WO 2006/035959 A1 divulgue un dispositif de protection contre des courants de fuite pouvant provoquer un choc électrique. US 5 245 495 A divulgue un dispositif de protection contre le phénomène d'embrasement généralisé éclair (flashover).

Ces courants de fuite à la terre peuvent, lors de leur apparition, déclencher des protections différentielles de courant résiduel aptes à interrompre le processus de charge.

Dans le cas où un utilisateur touche la carrosserie du véhicule électrique pendant la charge, les courants de fuite à la terre deviennent des courants dits de « toucher » ou de « contact », s'il y a un défaut de mise à la terre du véhicule. Ces courants de toucher sont limités par la norme internationale 61851-21 à 3.5mA.

Il a été proposé, dans le but de limiter ces courants, d'utiliser un transformateur créant une isolation galvanique entre le réseau de distribution et la batterie.

Les transformateurs utilisés sont des éléments volumineux dont la taille augmente avec la puissance de charge, ou avec le courant les traversant. Cette solution a donc pour inconvénient d'entraîner un coût supplémentaire ainsi qu'une augmentation du volume du dispositif, ce qui pénalise fortement le véhicule automobile électrique.

En outre, il est possible de raccorder les chargeurs actuels à des réseaux monophasé ou triphasés pour obtenir une puissance de charge plus élevée. Lors d'un raccordement à un réseau triphasé, les contraintes sur les transformateurs utilisés sont donc accrues.

Il a également été proposé de rediriger les courants de fuite vers le neutre du réseau électrique, par exemple au moyen d'une capacité reliée entre la carrosserie du véhicule électrique et le neutre.

Les solutions de limitations de courants ont pour inconvénient de ne pas pouvoir prendre en compte une augmentation des courants de fuite. Une telle augmentation peut provenir d'une augmentation de la capacité parasitique ou d'un défaut du système de compensation. Les systèmes de limitation des courants de fuite ne peuvent donc pas maintenir un courant de toucher sur le châssis inférieur à 3.5mA.

Au vu de ce qui précède, l'invention a pour but de fournir une estimation des courants de toucher, et de protéger le véhicule électrique lors des variations des courants de toucher.

Un autre but de l'invention est de maintenir la valeur des courants de toucher sous une valeur limite prédéfinie.

L'invention est définie selon les revendications ci-dessous. Selon un premier aspect, il est donc proposé un dispositif de protection d'un appareil électrique contre des courants de toucher, ledit appareil étant destiné à être connecté entre une source d'énergie électrique et un équipement embarqué à bord d'un véhicule automobile.

Ce dispositif comporte un circuit de détection des courants de fuite et d'estimation des courants de toucher destiné à venir se connecter sur des lignes de raccordement électrique de l'appareil, un circuit de mesure du courant de masse, et des moyens de commande de fonctionnement de l'appareil en fonction du niveau estimé des courants de toucher et du niveau mesuré du courant de masse.

Ainsi, les moyens de commande permettent d'autoriser ou d'empêcher l'alimentation en énergie électrique s'il y a une apparition de courants de fuite élevés ou une disparition de courants de fuite.

Avantageusement, la source d'énergie électrique peut être un réseau d'alimentation triphasé ou monophasé.

L'appareil électrique peut être un chargeur d'une batterie embarquée à bord du véhicule automobile, le véhicule automobile électrique étant un véhicule automobile à traction électrique ou hybride.

Selon un autre aspect, il est proposé un procédé de protection d'un appareil électrique contre des courants de toucher, ledit appareil étant destiné à être connecté entre une source d'énergie électrique et un équipement embarqué à bord d'un véhicule automobile.

Selon une caractéristique générale du procédé, le procédé comprend une détection des courants de fuite, une estimation des courants de toucher, une mesure du courant de masse, et une commande du fonctionnement de l'appareil en fonction du niveau estimé des courants de toucher et du niveau mesuré du courant de masse.

Avantageusement, on raccorde l'appareil électrique à la source d'énergie électrique et l'on empêche l'alimentation en énergie électrique de l'équipement embarqué en fonction du niveau estimé des courants de toucher et du niveau mesuré du courant de masse.

Ainsi, l'équipement embarqué n'est pas alimenté automatiquement lors du raccordement.

Si le courant de masse mesuré est inférieur à une première valeur de seuil définie alors on empêche l'alimentation en énergie électrique de l'équipement embarqué.

Un courant de masse trop faible peut signaler un défaut de raccordement à la terre, il est donc nécessaire d'empêcher l'alimentation en énergie électrique de l'équipement embarqué.

Si le courant de masse mesuré est supérieur à une deuxième valeur de seuil définie alors on autorise l'alimentation en énergie électrique de l'équipement embarqué.

Si l'estimation des courants de toucher est inférieure à une troisième valeur de seuil définie, alors on autorise l'alimentation en énergie électrique de l'équipement embarqué.

Si l'estimation des courants de toucher est supérieure à une quatrième valeur de seuil définie, alors on empêche l'alimentation en énergie électrique de l'équipement embarqué.

D'autres avantages et caractéristiques de l'invention apparaîtront à l'étude de la description suivante, prise à titre d'exemple non limitatif et illustrée par les dessins annexés sur lesquels :
- la figure 1 présente, de manière schématique, le principe général de protection contre des courants de fuite selon l'invention ;
- la figure 2 illustre un mode de réalisation d'un dispositif selon l'invention ; et
- la figure 3 illustre le fonctionnement d'un procédé de protection selon l'invention.

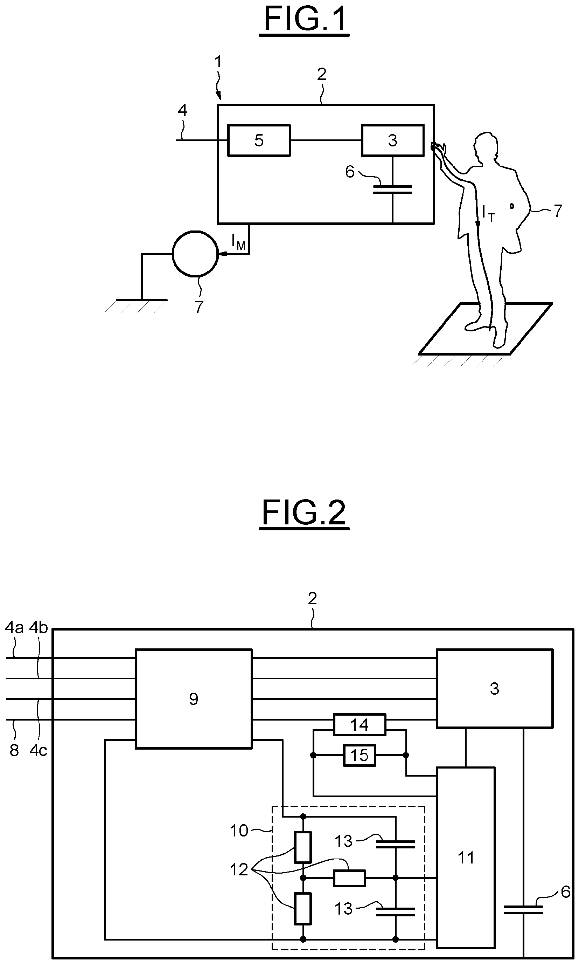

Sur la figure 1 on a représenté le principe de la génération de courants de fuite dans un véhicule électrique, auquel est raccordé un chargeur de batterie non isolé galvaniquement.

On notera toutefois que ce principe s'applique à tout type d'appareil, de type chargeur de batterie ou autre, notamment pour véhicule automobile à chaîne de traction électrique ou hybride dans lequel des courants de toucher sont susceptibles d'apparaître après raccordement de l'appareil lorsque l'on touche la carrosserie du véhicule.

Sur cette figure, la référence numérique 1 désigne le véhicule dans son ensemble et la référence 2 désigne une structure électriquement conductrice du véhicule, en l'espèce la carrosserie du véhicule.

Tel que représenté, le véhicule automobile électrique 1 est ici muni d'un chargeur 3 et comporte par ailleurs un ensemble de batteries et de chaîne de traction électrique non représentés sur cette figure.

Bien entendu, le véhicule 1 peut être, en outre, équipée de nombreux organes supplémentaires qui n'ont pas été représentés sur la figure pour des raisons de simplification.

Le chargeur 3 est relié au réseau d'alimentation par une connexion électrique 4. La connexion électrique 4 peut comporter plusieurs phases. Un dispositif de protection 5 du chargeur 3 est disposé sur la connexion électrique 4.

Lorsque le chargeur 3 est raccordé à un réseau électrique, une capacité parasite 6 crée un courant de fuite entre le chargeur 3 et la structure 2.

Si un utilisateur 7 touche la carrosserie du véhicule 2, ce dernier est traversé par un courant de toucher I_{T} créé à travers la capacité parasite 6.

Le courant de fuite produit également un courant de masse I_{M}.

Le dispositif de protection 5 permet de détecter l'apparition de courants de fuite et de commander le chargeur 3 en fonction, notamment, des courants de fuite.

La figure 2, sur laquelle on a détaillé l'architecture du dispositif de protection 5, illustre un véhicule 1 comportant trois connexions électriques 4a, 4b et 4c assurant le raccordement du véhicule à un réseau triphasé ou monophasé, et une connexion à la terre 8.

Le dispositif de protection 5 comporte un circuit 9 de détection des courants de fuite et d'estimation de courant de toucher, comportant des moyens de mesure de courant avantageusement choisi pour détecter les intensités à mesurer à travers les phases 4a, 4b, 4c et la connexion à la terre 8.

Le circuit 9 fournit une estimation en fonction du courant qui rentre dans le chargeur 3.

Le circuit 9 peut être constitué d'une mesure de flux électromagnétique par un tore de mesure comprenant les phases et la terre.

Ce circuit 9 peut aussi comprendre des moyens de calcul de la différence de mesure entre le courant de masse et le courant de fuite. La mesure du courant de fuite comprend la mesure du courant de fuite des trois phases.

Un circuit d'adaptation 10 permet ensuite d'adapter la sortie du circuit estimateur de courant de toucher 9 pour atteindre une unité de traitement 11. Le circuit d'adaptation 10 comprend un ensemble de trois résistances 12 et de deux capacités 13.

L'unité de traitement 11 comprend des moyens de commande du chargeur 3.

Un circuit de mesure des courants de masse 14 est disposé sur la connexion à la terre 8. Ce circuit 14 est relié, au moyen d'une résistance 15, à l'unité de traitement 11.

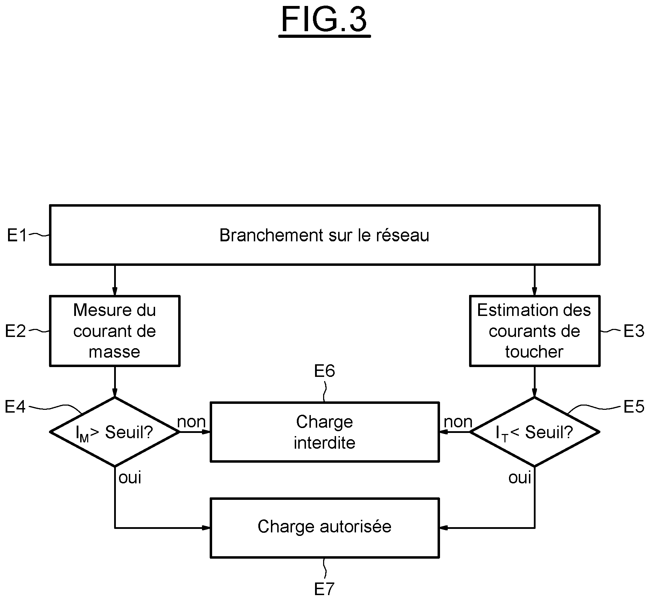

La figure 3 détaille les différentes étapes mises en œuvre au sein d'un dispositif de protection d'un appareil électrique contre des courants de fuite.

Ces étapes sont ici mises en œuvre au sein d'un véhicule automobile électrique 1 comportant un chargeur 3.

Le chargeur 3 est raccordé à un réseau d'alimentation électrique pouvant être monophasé ou triphasé lors d'un branchement effectué pendant l'étape E1.

Deux étapes de mesure et d'estimation E2 et E3 sont ensuite mise en œuvre simultanément. L'étape E2 correspond à la mesure du courant de masse I_{M} par le circuit 14. L'étape E3 correspond à l'estimation des courants de toucher I_{T} par le circuit 9.

L'étape E2 est suivie d'une étape de comparaison E4 dans laquelle le courant I_{M} est comparé à une ou plusieurs valeurs de seuil prédéfinies, par exemple lors de tests.

Par exemple, si le courant I_{M} mesuré est inférieur une première valeur de seuil, alors la quantité de courant rejoignant la masse est trop faible, ce qui peut indiquer un défaut de raccordement à la terre. La charge est interdite lors de l'étape E6.

Si le courant I_{M} est supérieur à une deuxième valeur de seuil définie, alors la quantité de courant sortant du chargeur 3 est suffisante pour indiquer qu'il y a un raccordement à la terre, et la charge est autorisée (étape E7).

L'étape E3 est suivie d'une étape de comparaison E5 dans laquelle le courant de toucher estimé I_{T} est comparé à une ou plusieurs valeurs de seuil prédéfinies.

Si le courant estimé I_{T} est inférieur à une troisième valeur de seuil prédéfinie, alors on peut autoriser la charge (étape E7), un utilisateur peut sans danger toucher la structure 2.

Si le courant estimé I_{T} est supérieur à une quatrième valeur de seuil prédéfinie, alors on interdit la charge (étape E6).

Comme précédemment, ces troisième et quatrième valeurs de seuils peuvent être obtenues par apprentissage préalable, et, de préférence, être fixées égales, par exemple à 3.5mA.

Grâce à l'invention, on bénéficie d'un dispositif pouvant être utilisé dans tout type d'appareil électrique non isolé. L'invention permet une protection des usagers et de l'appareil à chaque instant de son utilisation. De plus, la protection peut être mise en œuvre lors d'un raccordement à un réseau monophasé ou à un réseau triphasé.

Plus précisément, le procédé de protection selon l'invention peut comprendre une étape d'envoi d'un message, sur détection d'un courant de toucher I_{T} trop important ou d'un courant de masse I_{M} trop faible, au réseau d'alimentation de l'appareil électrique 3, afin de stopper la charge de l'appareil électrique 3.

Notamment dans le cas où l'appareil électrique 3 est un véhicule électrique, ce message est par exemple envoyé depuis un calculateur du véhicule gérant la charge électrique du véhicule, sur une ligne de communication dite « ligne pilote », à la borne de charge alimentant l'appareil électrique 3. Sur réception de ce message la borne de charge ouvre un contacteur déconnectant les connexions 4a, 4b, 4c et 8 du réseau triphasé ou monophasé alimentant jusqu'alors le véhicule.

## Revendications

1. Dispositif de protection (5) d'un appareil électrique (3) contre des courants de toucher, ledit appareil (3) étant destiné à être connecté entre une source d'énergie électrique et un équipement embarqué à bord d'un véhicule automobile (1),
**caractérisé en ce que** le dispositif de protection (5) comporte un circuit (9) de détection des courants de fuite et d'estimation des courants de toucher (IT) destiné à venir se connecter sur des lignes de raccordement électrique (4a, 4b, 4c, 8) de l'appareil (3), les courants de fuite comprenant les courants de toucher et le courant de masse, le dispositif de protection (5) comportant un circuit de mesure du courant de masse (14), et des moyens de commande de fonctionnement (11) de l'appareil (3) en fonction du niveau estimé des courants de toucher (IT) et du niveau mesuré du courant de masse (IM),
les moyens de commande étant agencés pour comparer les courants de toucher estimés à une première valeur de seuil de courant de toucher prédéfinie, et pour comparer le courant de masse mesuré à une deuxième valeur de seuil de courant de masse prédéfinie, et pour, d'une part, autoriser (E7) le fonctionnement de l'appareil électrique si le courant de masse mesuré est supérieur à la deuxième valeur de seuil prédéfinie et si le courant de toucher estimé est inférieur à la première valeur de seuil prédéfinie, et pour, d'autre part, interdire (E6) le fonctionnement de l'appareil électrique si le courant de masse mesuré est inférieur à la deuxième valeur de seuil prédéfinie et si le courant de toucher estimé est supérieur à la première valeur de seuil prédéfinie.

2. Dispositif selon la revendication 1, **caractérisé en ce que** la source d'énergie électrique est un réseau d'alimentation triphasé ou monophasé.

3. Dispositif selon l'une des revendications 1 ou 2, **caractérisé en ce que** les moyens de commande (11) étant agencées pour autoriser ou empêcher l'alimentation en énergie électrique à l'appareil électrique (3), étant un chargeur pour une batterie embarqué à bord du véhicule automobile (1), ledit véhicule automobile électrique (1) étant un véhicule automobile à traction électrique ou hybride.

4. Procédé réalisé par un dispositif (5) de protection d'un appareil électrique (3) contre des courants de toucher, ledit appareil (3) étant destiné à être connecté entre une source d'énergie électrique et un équipement embarqué à bord d'un véhicule automobile (1),
**caractérisé en ce que** le dispositif de protection (5) comprend une détection des courants de fuite, une estimation des courants de toucher (IT), une mesure du courant de masse, les courants de fuite comprenant les courants de toucher et le courant de masse, le procédé comprenant la comparaison des courants de toucher estimés à une première valeur de seuil de courant de toucher prédéfinie, la comparaison du courant de masse mesuré à une deuxième valeur de seuil de courant de masse prédéfinie et une commande du fonctionnement de l'appareil telle que, le fonctionnement de l'appareil électrique est, d'une part, autorisé (E7) si le courant de masse mesuré est supérieur à la deuxième valeur de seuil prédéfinie et si le courant de toucher estimé est inférieur à la première valeur de seuil prédéfinie, et pour, d'autre part, interdire (E6) le fonctionnement de l'appareil électrique si le courant de masse mesuré est inférieur à la deuxième valeur de seuil prédéfinie et si le courant de toucher estimé est supérieur à la première valeur de seuil prédéfinie.

5. Procédé selon la revendication 4, comprenant un raccordement de l'appareil électrique (3) à la source d'énergie électrique et l'empêchement de l'alimentation en énergie électrique de l'équipement embarqué en fonction du niveau estimé des courants de toucher et du niveau mesuré du courant de masse.

6. Procédé selon l'une des revendications 4 ou 5, comprenant l'empêchement de l'alimentation en énergie électrique de l'équipement embarqué si le courant de masse mesuré (IM) est inférieur à la première valeur de seuil.

7. Procédé selon l'une quelconque des revendications 4 à 6, comprenant l'autorisation de l'alimentation en énergie électrique de l'équipement embarqué si le courant de masse mesuré (IM) est supérieur à une deuxième valeur de seuil.

8. Procédé selon l'une quelconque des revendications 4 à 7, comprenant l'autorisation de l'alimentation en énergie électrique de l'équipement embarqué si l'estimation des courants de toucher (IT) est inférieure à une troisième valeur de seuil.

9. Procédé selon l'une quelconque des revendications 4 à 8, comprenant l'empêchement de l'alimentation en énergie électrique de l'équipement embarqué si l'estimation des courants de toucher (IT) est supérieure à une quatrième valeur de seuil définie.

10. Procédé selon l'une quelconque des revendications 5 à 9, comprenant l'arrêt de l'alimentation en énergie électrique de l'équipement embarqué est effectué par envoi d'un message depuis ledit équipement embarqué sur une ligne de communication vers une borne de charge.

## Patentansprüche

1. Vorrichtung (5) zum Schutz eines elektrischen Geräts (3) vor Berührungsströmen, wobei das Gerät (3) dazu bestimmt ist, zwischen einer Quelle elektrischer Energie und einer an Bord eines Kraftfahrzeugs (1) befindlichen Ausrüstung verbunden zu werden,
**dadurch gekennzeichnet, dass** die Schutzvorrichtung (5) eine Schaltung (9) zur Erfassung der Leckströme und zur Schätzung der Berührungsströme (IT) aufweist, die dazu bestimmt ist, mit elektrischen Anschlussleitungen (4a, 4b, 4c, 8) des Geräts (3) verbunden zu werden, wobei die Leckströme die Berührungsströme und den Massestrom enthalten, wobei die Schutzvorrichtung (5) eine Schaltung zum Messen des Massestroms (14) und Einrichtungen zum Steuern des Betriebs (11) des Geräts (3) abhängig vom geschätzten Pegel der Berührungsströme (IT) und vom gemessenen Pegel des Massestroms (IM) aufweist,
wobei die Steuereinrichtungen eingerichtet sind, um die geschätzten Berührungsströme mit einem vordefinierten ersten Berührungsstrom-Schwellwert zu vergleichen, und um den gemessenen Massestrom mit einem vordefinierten zweiten Massestrom-Schwellwert zu vergleichen, und um einerseits den Betrieb des elektrischen Geräts zu erlauben (E7), wenn der gemessene Massestrom höher ist als der vordefinierte zweite Schwellwert, und wenn der geschätzte Berührungsstrom niedriger ist als der vordefinierte erste Schwellwert, und um andererseits den Betrieb des elektrischen Geräts zu verbieten (E6), wenn der gemessene Massestrom niedriger ist als der vordefinierte zweite Schwellwert und der geschätzte Berührungsstrom höher ist als der vordefinierte erste Schwellwert.

2. Vorrichtung nach Anspruch 1, **dadurch gekennzeichnet, dass** die elektrische Energiequelle ein dreiphasiges oder einphasiges Versorgungsnetz ist.

3. Vorrichtung nach einem der Ansprüche 1 oder 2, **dadurch gekennzeichnet, dass** die Steuereinrichtungen (11), die eingerichtet sind, um die Versorgung des elektrischen Geräts (3) mit elektrischer Energie zu erlauben oder zu verhindern, ein Ladegerät für eine an Bord des Kraftfahrzeugs (1) befindliche Batterie sind, wobei das elektrische Kraftfahrzeug (1) ein Kraftfahrzeug mit elektrischem oder hybridem Antrieb ist.

4. Verfahren, das von einer Vorrichtung (5) zum Schutz eines elektrischen Geräts (3) vor Berührungsströmen durchgeführt wird, wobei das Gerät (3) dazu bestimmt ist, zwischen einer Quelle elektrischer Energie und einer an Bord eines Kraftfahrzeugs (1) befindlichen Ausrüstung verbunden zu werden,
**dadurch gekennzeichnet, dass** die Schutzvorrichtung (5) eine Erfassung der Leckströme, eine Schätzung der Berührungsströme (IT), eine Messung des Massestroms enthält, wobei die Leckströme die Berührungsströme und den Massestrom enthalten, wobei das Verfahren den Vergleich der geschätzten Berührungsströme mit einem vordefinierten ersten Berührungsstrom-Schwellwert, den Vergleich des gemessenen Massestroms mit einem vordefinierten zweiten Massestrom-Schwellwert, und eine derartige Steuerung des Betriebs des Geräts enthält, dass der Betrieb des elektrischen Geräts einerseits erlaubt wird (E7), wenn der gemessene Massestrom höher ist als der vordefinierte zweite Schwellwert, und wenn der geschätzte Berührungsstrom niedriger ist als der vordefinierte erste Schwellwert, und andererseits der Betrieb des elektrischen Geräts verboten wird (E6), wenn der gemessene Massestrom niedriger ist als der vordefinierte zweite Schwellwert, und wenn der geschätzte Berührungsstrom höher ist als der vordefinierte erste Schwellwert.

5. Verfahren nach Anspruch 4, das einen Anschluss des elektrischen Geräts (3) an die Quelle elektrischer Energie und das Verhindern der Versorgung der an Bord befindlichen Ausrüstung mit elektrischer Energie abhängig vom geschätzten Pegel der Berührungsströme und vom gemessenen Pegel des Massestroms enthält.

6. Verfahren nach einem der Ansprüche 4 oder 5, das das Verhindern der Versorgung der an Bord befindlichen Ausrüstung mit elektrischer Energie enthält, wenn der gemessene Massestrom (IM) niedriger ist als der erste Schwellwert.

7. Verfahren nach einem der Ansprüche 4 bis 6, das das Erlauben der Versorgung der an Bord befindlichen Ausrüstung mit elektrischer Energie enthält, wenn der gemessene Massestrom (IM) höher ist als ein zweiter Schwellwert.

8. Verfahren nach einem der Ansprüche 4 bis 7, das das Erlauben der Versorgung der an Bord befindlichen Ausrüstung mit elektrischer Energie enthält, wenn die Schätzung der Berührungsströme (IT) niedriger ist als ein dritter Schwellwert.

9. Verfahren nach einem der Ansprüche 4 bis 8, das das Verhindern der Versorgung der an Bord befindlichen Ausrüstung mit elektrischer Energie enthält, wenn die Schätzung der Berührungsströme (IT) höher ist als ein vordefinierter vierter Schwellwert.

10. Verfahren nach einem der Ansprüche 5 bis 9, das die Unterbrechung der Versorgung der an Bord befindlichen Ausrüstung mit elektrischer Energie durch Senden einer Nachricht von der an Bord befindlichen Ausrüstung auf einer Kommunikationsleitung an eine Ladestation enthält.

## Claims

1. Device (5) for protecting an electrical apparatus (3) against touch currents, said apparatus (3) being designed to be connected between an electrical power source and an item of equipment on board a motor vehicle (1), **characterized in that** the protection device (5) comprises a circuit (9) for detecting leakage currents and for estimating touch currents (IT), designed to be connected to electrical connection lines (4a, 4b, 4c, 8) of the apparatus (3), the leakage currents comprising the touch currents and the ground current, the protection device (5) comprising a circuit (14) for measuring the ground current, and means (11) for controlling the operation of the apparatus (3) according to the estimated level of the touch currents (IT) and to the measured level of the ground current (IM), the control means being designed to compare the estimated touch currents with a first predefined touch current threshold value and to compare the measured ground current with a second predefined ground current threshold value, and to authorize (E7) the operation of the electrical apparatus if the measured ground current is above the second predefined threshold value and if the estimated touch current is below the first predefined threshold value, on the one hand, and to prevent (E6) the operation of the electrical apparatus if the measured ground current is below the second predefined threshold value and if the estimated touch current is above the first predefined threshold value, on the other hand.

2. Device according to Claim 1, **characterized in that** the electrical power source is a three-phase or single-phase power supply network.

3. Device according to either of Claims 1 and 2, **characterized in that** the control means (11) are designed to authorize or prevent the supply of electrical power to the electrical apparatus (3), the latter being a charger for a battery on board the motor vehicle (1), said electrical motor vehicle (1) being a motor vehicle with electrical or hybrid drive.

4. Method, performed by a device (5), for protecting an electrical apparatus (3) against touch currents, said apparatus (3) being designed to be connected between an electrical power source and an item of equipment on board a motor vehicle (1),
**characterized in that** the protection device (5) comprises detecting the leakage currents, estimating the touch currents (IT), measuring the ground current, the leakage currents comprising the touch currents and the ground current, the method comprising comparing the estimated touch currents with a first predefined touch current threshold value, comparing the measured ground current with a second predefined ground current threshold value, and controlling the operation of the apparatus such that the operation of the electrical apparatus is authorized (E7) if the measured ground current is above the second predefined threshold value and if the estimated touch current is below the first predefined threshold value, on the one hand, and the operation of the electrical apparatus is prevented (E6) if the measured ground current is below the second predefined threshold value and if the estimated touch current is above the first predefined threshold value, on the other hand.

5. Method according to Claim 4, comprising connecting the electrical apparatus (3) to the electrical power source and preventing the supply of electrical power to the onboard equipment according to the estimated level of the touch currents and to the measured level of the ground current.

6. Method according to either of Claims 4 and 5, comprising preventing the supply of electrical power to the onboard equipment if the measured ground current (IM) is below first threshold value.

7. Method according to any one of Claims 4 to 6, comprising authorizing the supply of electrical power to the onboard equipment if the measured ground current (IM) is above a second threshold value.

8. Method according to any one of Claims 4 to 7, comprising authorizing the supply of electrical power to the onboard equipment if the estimation of the touch currents (IT) is below a third threshold value.

9. Method according to any one of Claims 4 to 8, comprising preventing the supply of electrical power to the onboard equipment if the estimation of the touch currents (IT) is above a fourth defined threshold value.

10. Method according to any one of Claims 5 to 9, comprising stopping the supply of electrical power to the onboard equipment by sending a message from said onboard equipment over a communication line to a charging terminal.
